# EUROPEAN PATENT SPECIFICATION

(11) **EP 1 622 225 B1**
(45) Date of publication and mention of the grant of the patent: **28.02.2007**
(21) Application number: 05106937.5
(22) Date of filing: 27.07.2005
(51) Int. Cl.: H01R 13/03, H01R 4/02

(54) **An electrical connector**
Elektrischer Steckverbinder
Connecteur électrique

(30) Priority: 30.07.2004 JP 2004223418
(43) Date of publication of application: 01.02.2006
(73) Proprietor: Tyco Electronics AMP K.K., Kawasaki-shi, Kanagawa 213-8535 (JP)
(72) Inventor: Yamagami, Hidehisa Tyco Electronics AMP K.K., Kanagawa 213-8535 (JP); Nishida, Atsushi, Toyota-shi, Aichi 471-8571 (JP); Minikata, Masato, Toyota-shi, Aichi 471-8571 (JP); Kobayashi, Hiroshi, Toyota-shi, Aichi 471-8571 (JP); Furuyama, Ken Tyco Electronics AMP K.K., Kanagawa 213-8535 (JP)
(74) Representative: Johnstone, Douglas Ian

(56) References cited:
- EP-A- 0 147 039
- US-A1- 2001 018 299
- US-A1- 2003 025 182
- PATENT ABSTRACTS OF JAPAN vol. 1999, no. 13, 30 November 1999 (1999-11-30) -& JP 11 214050 A (SUMITOMO WIRING SYST LTD), 6 August 1999 (1999-08-06)
- PATENT ABSTRACTS OF JAPAN vol. 2000, no. 19, 5 June 2001 (2001-06-05) & JP 2001 043919 A (SUMITOMO WIRING SYST LTD), 16 February 2001 (2001-02-16)

## Description

The present invention relates to an electrical connector including a plurality of terminals each having a contact section that contacts a mating contact at one end and having a connecting section which connects to a circuit board at the other end. The connector also includes a bent section at a middle portion between the contact section and the connecting section, and a housing which holds the plurality of terminals.

Conventionally, a board-mount electrical connector includes a plurality of terminals, and a housing which holds these terminals in a regularly arranged state, (see for example, see Japanese Patent No. 3538747, page 2 to 4, and Fig. 1). Here, each terminal has at one end a male contact section, which extends substantially parallel with the circuit board in the housing, and is inserted into a female contact of a mating connector, and at the other end a connecting section which extends in a direction substantially perpendicular to the circuit board outside the housing and is connected to the circuit board by soldering. A portion between the contact section and the connecting section is formed to bend behind a rear wall of the housing to reach the connecting section.

For each terminal, tin-plating is applied to the entire terminal from the contact section to the connecting section, and a relatively thick tin-plated layer is formed on the connecting section which is soldered to the circuit board. For the terminal of the electrical connector, a copper alloy including zinc is used as a base material. When tin-plating is applied to such a base material, an alloying phenomenon of tin and zinc takes place inside the tin-plated layer, which advances with time from the base material side to an outer surface of the layer. Here, if the storage period of the electrical connector is too long and the alloying phenomenon reaches the surface of the tin-plated layer, the alloy of tin and zinc appears on the surface. This alloy prevents affinity of the connecting section and solder at the time of soldering, and reduces solderability of the connecting section. Therefore, a relatively thick tin-plated layer is formed on the connecting section, and the term before the alloying phenomenon reaches the surface of the tin-plated layer is made longer, so that favorable solderability of the connecting section can be maintained over a long period.

However, in the terminal of the electrical connector, internal stress remains at a bent portion between the contact section and the connecting section, and there is a high possibility that over time, an electrically conductive needle crystal called "a whisker" will grow in or from the tin-plated surface of the terminal due to such internal stress. If such a whisker occurs in the terminal of the electrical connector, one problem that may arise, for example, is that the whisker electrically short-circuits the adjacent terminals or the like.

The present invention has been made in view of the above circumstances and provides a board-mount electrical connector which is capable of maintaining favorable solderability of a connecting section of a terminal over a long period, and preventing the occurrence of a whisker in or on a bent section of the terminal.

According to the present invention there is provided an electrical connector comprising a plurality of terminals each having at one end a contact section which contacts a mating contact and having at the other end a connecting section which connects to a circuit board, and each further having a bent section in a middle portion between the contact section and the connecting section, and a housing which holds the plurality of terminals,
wherein a surface of the terminal, apart from a middle portion, is tin-plated, and the connecting section has a thicker tin-plated layer than the contact section.

The tin-plating mentioned here includes plating using a tin alloy such as a tin-copper alloy, a tin-bismuth alloy or the like, which does not include lead, as well as plating with pure tin.

The shape of the bent section may be in any shape irrespective of the dimension of a radius of curvature, and may be in a shape which is bent at a plurality of spots.

Tin plating is applied to a surface of the terminal of the electrical connector except for the middle portion where the bent section is included and the internal stress remains which might cause the possibility of the occurrence of a whisker if it was plated. Namely, according to the electrical connector of the present invention, the portion having the possibility of occurrence of a whisker in or on the terminal is excluded from the range of tin plating, and therefore, occurrence of a whisker can be prevented. Since the connecting section has a thicker tin-plated layer than the contact section, favorable solderability of the connecting section can be maintained for a long period.

Preferably, the terminal has a bright tin-plated layer on the contact section, and has a semi-bright tin-plated layer on the connecting section.

Preferably, the contact section has a bright tin-plated layer, consequently friction occurring at the time of fitting of the contact section of the terminal and the mating contact is minimised. Therefore, the electrical connector can be easily inserted into the mating connector with a small force, and the contact section is less vulnerable during insertion and extraction. Furthermore, the bright tin-plated layer has a smooth surface, and a relatively small exposed surface area, and therefore, it is resistant to oxidizing and has excellent weatherability. The connecting section has a semi-bright (matt) tin-plated layer, and therefore, it provides favorable solderability when soldered to the circuit board.

As explained above, according to the present invention, a board-mount electrical connector capable of maintaining favorable solderability of the connecting section of the terminal for a long period, and preventing occurrence of a whisker can be provided.

An embodiment of the present invention will now be described, with reference to the accompanying drawings, in which:
Fig. 1 is a sectional view showing one embodiment of an electrical connector of the present invention; and
Fig. 2 is a sectional view schematically showing a plated layer of a contact shown in Fig. 1.

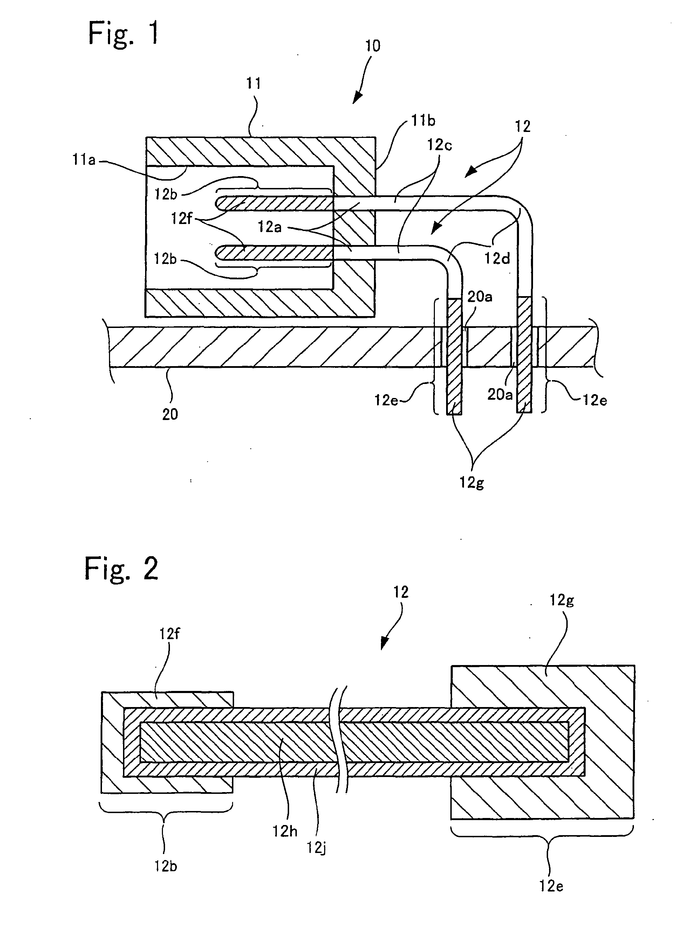

A connector 10 shown in Fig. 1 has an insulating housing 11 fixed to a circuit board 20 by a screwing section not shown, and plural contacts 12 held by the insulating housing 11. Here, the insulating housing 11 and the contact 12 respectively correspond to each example of the housing and terminal described in the present invention.

The insulating housing 11 has a recessed fitting section 11a into which a mating connector (not shown) is inserted. A plurality of contacts 12 are arranged one above the other, in a direction perpendicular to the plane of the drawing, in the insulating housing 11.

The contact 12 includes: a held section 12a held by a rear wall 11b of the insulating housing 11; a male contact section 12b which linearly extends into the insulating housing 11 from the held section 12a, and which is inserted into a mating female contact (not shown) to electrically contact the mating contact; an extended section 12c which linearly extends outside the insulating housing 11 from the held section 12a; a bent section 12d which connects to the extended section 12c; and a connecting section 12e extending substantially orthogonally to the circuit board 20 from the bent section 12d, and which passes through a through-hole 20a of the circuit board 20 and is connected to the circuit board 20 by soldering with solder which does not include lead, such as tin-copper solder, for example. Here, the contact section 12b and the connecting section 12e respectively correspond to each example of the contact section and the connecting section described in the present invention. The combination of the held section 12a, the extended section 12c and the bent section 12d correspond to an example of the middle section described in the present invention, and the bent section 12d corresponds to an example of the bent section described in the present invention.

Nickel plating is applied to the entirety of the contact 12. To each of the contact sections 12b and the connecting sections 12e, except for the held section 12a, the extended section 12c and the bent section 12d, a suitable tin plating material is applied. Namely, a bright tin-plated layer 12f, which is less vulnerable to insertion and extraction with respect to the mating female contact and capable of minimizing the insertion resistance, is formed on the contact section 12b, and a semi-bright tin-plated layer 12g capable of obtaining favorable solderability is formed on the connecting section 12e.

Fig. 2 is a sectional view schematically showing the plated layers of the contact shown in Fig. 1.

The contact 12 has a structure in which a nickel-plated layer 12j is formed on an entire surface of a base material 12h of a copper alloy including zinc. As described above, the bright tin-plated layer 12f is formed on the contact section 12b, and the semi-bright tin-plated layer 12g is formed on the connecting section 12e. The thickness of the semi-bright tin-plated layer 12g of the connecting section 12e is larger as compared with the thickness of the bright tin-plated layer 12f of the contact section 12b. As a result, the period before the alloy of zinc and tin, which lowers solderability, appears on the semi-bright tin-plated layer 12g after the semi-bright tin-plated layer 12g is formed on the connecting section 12e is lengthened. Therefore, favorable solderability of the connecting section 12b is maintained for a greater time in this embodiment.

Further, in this embodiment, tin plating is not applied to the bent section 12d where internal stress remains and has the possibility of creating a whisker which causes a problem of electrical short circuit between the adjacent contacts when tin plating is applied. Namely, according to the electrical connector 12 of this embodiment, occurrence of a whisker can be prevented.

In the above description, composition of tin used for plating is not especially referred to, but the tin may be a tin alloy which does not include lead, such as, for example, a tin-copper alloy and a tin-bismuth alloy other than pure tin.

In the above description, the insulating housing 11 fixed by the screwing section is described as an example of the housing described in the present invention, but the present invention is not limited to this, and the housing of the present invention may be the one having a fixture such as a plate-shaped fitting (retention leg), for example.

## Claims

1. An electrical connector (10) comprising a plurality of terminals (12) each having at one end a contact section (12b) for contacting a mating contact and having at the other end a connecting section (12e) for connecting to a circuit board (20), and each further having a bent section (12d) in a middle portion between the contact section (12b) and the connecting section (12e), and a housing (11) which holds the plurality of terminals (12),
wherein a surface of the terminals, apart from the middle portion, is tin plated, and the connecting section (12e) has a thicker tin-plated layer than the contact section (12b).

2. The electrical connector according to claim 1, wherein each terminal has a bright tin-plated layer (12f) on the contact section (12b) , and has a semi-bright tin-plated layer (12g) on the connecting section (12e).

## Patentansprüche

1. Elektrischer Verbinder (10), der aufweist: eine Vielzahl von Anschlussklemmen (12), von denen eine jede an einem Ende einen Kontaktabschnitt (12b) für das Kontaktieren eines Gegenkontaktes und am anderen Ende einen Verbindungsabschnitt (12e) für das Verbinden mit einer Leiterplatte (20) aufweist, und wobei eine jede außerdem einen gebogenen Abschnitt (12d) in einem mittleren Abschnitt zwischen dem Kontaktabschnitt (12b) und dem Verbindungsabschnitt (12e) aufweist; und ein Gehäuse (11), das die Vielzahl der Anschlussklemmen (12) hält,
wobei eine Fläche der Anschlussklemmen, abgesehen vom mittleren Abschnitt, verzinnt ist und der Verbindungsabschnitt (12e) eine dickere verzinnte Schicht als der Kontaktabschnitt (12b) aufweist.

2. Elektrischer Verbinder nach Anspruch 1, bei dem jede Anschlussklemme eine glänzende verzinnte Schicht (12f) auf dem Kontaktabschnitt (12b) und eine halbglänzende verzinnte Schicht (12g) auf dem Verbindungsabschnitt (12e) aufweist.

## Revendications

1. Connecteur électrique (100) comprenant plusieurs bornes (12), comportant chacune au niveau d'une extrémité une section de contact (12b) pour contacter un contact complémentaire, et comportant au niveau de l'autre extrémité une section de connexion (12e) destinée à être connectée à une carte à circuit imprimé (20), chacune comportant en outre une section fléchie (12d) dans une partie centrale entre la section de contact (12b) et la section de connexion (12e), et un boîtier (11) retenant les plusieurs bornes (12);
une surface des bornes, excepté la partie centrale, étant étamée, et la section de connexion (12e) comportant une couche étamée plus épaisse que la section de contact (12b).

2. Connecteur électrique selon la revendication 1, dans lequel chaque borne comporte une couche étamée lustrée (12f) sur la section de contact (12b) et comporte une couche étamée semi-lustrée (12g) sur la section de connexion (12e).
